(19) Europäisches Patentamt / European Patent Office / Office européen des brevets

(11) **EP 2 816 724 A1**

(12) **EUROPEAN PATENT APPLICATION**
published in accordance with Art. 153(4) EPC

(43) Date of publication:
**24.12.2014 Bulletin 2014/52**

(51) Int Cl.:
*H02N 11/00* (2006.01)        *H02N 2/00* (2006.01)
*H02N 2/18* (2006.01)

(21) Application number: **13748909.2**

(22) Date of filing: **13.02.2013**

(86) International application number:
**PCT/JP2013/053426**

(87) International publication number:
**WO 2013/122110 (22.08.2013 Gazette 2013/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **15.02.2012  JP 2012031171**
**15.02.2012  JP 2012031172**

(71) Applicant: **Bando Chemical Industries, Ltd.**
**Kobe-shi, Hyogo 650-0047 (JP)**

(72) Inventors:
• **KATO Hideyuki**
  **Kobe-shi**
  **Hyogo 650-0047 (JP)**
• **OTAKA Hideo**
  **Kobe-shi**
  **Hyogo 650-0047 (JP)**
• **NONAKA Keizo**
  **Kobe-shi**
  **Hyogo 650-0047 (JP)**

(74) Representative: **Schulz, Björn**
  **Maxton Langmaack & Partner**
  **Postfach 51 08 06**
  **50944 Köln (DE)**

(54) **PIEZOELECTRIC ELEMENT, ACTUATOR ELEMENT, ACTUATOR, POWER GENERATING ELEMENT, POWER GENERATING DEVICE AND FLEXIBLE SHEET**

(57)    A piezoelectric element is provided which enables superior piezoelectric effects to be attained while having a comparatively simple structure and being easy to produce. The piezoelectric element according to the present invention includes a plurality of strip-shaped flexible sheets having: a dielectric elastomer layer; and an electrode layer that is stretchable and laminated on the dielectric elastomer layer, the plurality of flexible sheets being superposed crosswise on each other and alternately folded in an accordion shape such that the flexible sheets are alternately stacked. It is preferred that at least one of the plurality of flexible sheets includes a pair of the dielectric layers laminated on front and back face sides of the electrode layer. The pair of flexible sheets are preferably superposed on each other crosswise at substantially right angles. The flexible sheets are preferably stacked to give no less than 10 layers and no greater than 10,000 layers.

F I G.  1

EP 2 816 724 A1

**Description**

[TECHNICAL FIELD]

The present invention relates to a piezoelectric element, an actuator element, an actuator, a power generating element, a power generating device and a flexible sheet.

[BACKGROUND ART]

Hitherto, an actuator that has a structure in which a dielectric elastomer layer is sandwiched between a pair of stretchable electrode layers is known. In the actuator, when a voltage is applied to the electrode layers, the dielectric elastomer layer is stretched in a planar direction under an electric field between the electrode layers. In other words, the actuator is an expandable actuator that is unexpanded in a voltage non-applied state and expanded in a voltage applied state, and therefore, when the actuator is used at a site where the actuator is normally in an expanded state and is desired to be relieved from the expanded state as needed, it is necessary to constantly apply a voltage to the electrode layers. Since normally such an expandable actuator is not in its original shape but in a deformed state, deterioration of the electrode layers and the dielectric elastomer layer is likely to be caused in such an expandable actuator. In addition, since a voltage is constantly applied to the electrode layers, such an actuator has a disadvantage that care is required to inhibit adverse effects of the voltage on the surroundings and additionally the applied electric energy is lost, resulting in an increase in cost.

A contractable actuator is also known in which a plurality of first stretchable electrode layers and a plurality of second stretchable electrode layers are alternately disposed at a predetermined interval and a dielectric elastomer layer is disposed between the first electrode layer and the second electrode layer (see Japanese Unexamined Patent Application, Publication No. 2011-103713). In the contractable actuator, when a voltage is applied to the first electrode layer and the second electrode layer, each dielectric elastomer layer is stretched in a planar direction, leading to contraction of the actuator along a direction of the thickness of the overlaid structure. However, in the contractable actuator having such a structure, it is necessary to electrically connect each of the plurality of first electrode layers and the plurality of second electrode layers, leading to a complicated wiring structure. In particular, in order to increase a contraction amount and a contractile force, a large number of electrode layers are required to be laminated, and this may lead to a more complicated wiring structure, resulting in imperfections of the electrical connection and/or defects in manufactured products.

In addition, an actuator is also known which includes a pair of electrode tapes and a plurality of rigid plate members, the pair of electrode tapes being each supported by the rigid plate members and alternately overlaid crosswise such that predetermined gaps (air layer) are formed between the pair of electrode tapes (see Japanese Unexamined Patent Application, Publication No. 2010-57321). The actuator has a structure in which a plate member, an electrode tape, another plate member, an air layer (gap), still another plate member, another electrode tape, yet still another plate member and another air layer are arranged in this order. In the actuator, when a voltage is applied to the pair of electrode tapes, a force is exerted in a direction along which the electrode tapes are brought closer to each other, by an electrostatic force. Then, the force reduces the gap between the plate members, and the actuator is wholly contracted along a direction of the thickness of the overlaid structure. However, in the actuator, in order to permit the actuator to be contracted, the gap (air layer) is necessary between the plate members. The presence of the gap increases an interval between the electrode tapes, and as a result, the electrostatic force exerted on the electrode tapes is reduced.

In other words, the actuator has a disadvantage that when the gap is thickened for the purpose of increasing the contraction amount, a contractile force is reduced, whereas when the gap is thinned for the purpose of increasing the contractile force, the contraction amount is reduced. Moreover, since the gap exists between the plate members, a mechanism is necessary for supporting the plate member to be movable along a direction of the thickness of the overlaid structure, and thus, in order to properly utilize the force, precision of the mechanism may be required, leading to an increase in product cost.

Moreover, a power generating element that has a sheet structure in which a dielectric elastomer layer is sandwiched between a pair of stretchable electrode layers is known (see Japanese Unexamined Patent Application (Translation of PCT Application), Publication No. 2003-505865; and Japanese Unexamined Patent Application, Publication No. 2010-263750). The power generating element generates electric power utilizing a change of a capacitance arising from a course of deformation (stretching and shrinkage), that is, stretching in a planar direction followed by restoration (shrinkage). The electric power J generated in a single process of stretching and shrinkage of the power generating element is represented by the following equation (1):

$$J = (1/2) \times C1 \times V1^2 \times (C1/C2 - 1) \quad \cdots \quad \text{equation (1)}$$

wherein C1 represents a capacitance in a stretched state; C2 represents a capacitance in a shrunk state; and V1 represents a bias voltage applied in the stretched state.

The capacitance C is represented by the following equation (2):

$$C = \varepsilon_0 \times \varepsilon \times A/t = \varepsilon_0 \times \varepsilon \times b/t^2 \quad \cdots \quad \text{equation (2)}$$

wherein $\varepsilon_0$ represents a permittivity of a free space; $\varepsilon$ represents a relative permittivity of the dielectric elastomer layer; A represents an electrode area; t represents a distance between the electrodes, i.e., the thickness of the dielectric elastomer layer; and b represents a volume of a space between the electrodes, i.e., a volume of the dielectric elastomer layer and is a product of A and t (i.e., b = A x t).

Moreover, the capacitance C1 in the stretched state and the capacitance C2 in the shrunk state are represented by the equations (3) and (4), respectively:

$$C1 = \varepsilon_0 \times \varepsilon \times A1/t1 = \varepsilon_0 \times \varepsilon \times b1/t1^2 \quad \cdots \quad \text{equation (3)}$$

$$C2 = \varepsilon_0 \times \varepsilon \times A2/t2 = \varepsilon_0 \times \varepsilon \times b2/t2^2 \quad \cdots \quad \text{equation (4)}$$

wherein A1 represents an electrode area in the stretched state; t1 represents a distance between the electrodes, i.e., the thickness of the dielectric elastomer layer, in the stretched state; b1 represents a volume of a space between the electrodes, i.e., a volume of the dielectric elastomer layer, in the stretched state and is a product of A1 and t1 (i.e., b1 = A1 x t1) ; A2 represents an electrode area in the shrunk state; t2 represents a distance between the electrodes, i.e., the thickness of the dielectric elastomer layer, in the shrunk state; and b2 represents a volume of a space between the electrodes, i.e., a volume of the dielectric elastomer layer, in the shrunk state and is a product of A2 and t2 (i.e., b2 = A2 x t2).

It is to be noted that in an ideal state of an elastomer having a Poisson's ratio of 0.5, the volume thereof in a stretched state and the volume thereof in a shrunk state are the same (i.e., b1 = b2) and the capacitance will be in inverse proportion to the square of thickness t. Accordingly, the capacitance C1 in the stretched state and the capacitance C2 in the shrunk state satisfy a relationship represented by the equation (5) :

$$C1/C2 = t2^2/t1^2 \quad \cdots \quad \text{equation (5)}$$

Using the equations (5) and (3), the equation (1) can be rewritten as the following equation (6) :

$$J = (1/2) \times \varepsilon_0 \times \varepsilon \times A1/t1 \times V1^2 \times (t2^2/t1^2 - 1) \quad \cdots \quad \text{equation (6)}$$

In the equation (6), provided that $\varepsilon$, A1 and t1 are constant in an initial state, the generated electric power J will be in proportion to the square of the bias voltage V1 and the square of the thickness ratio t2/t1.

Given these, for the purpose of increasing the electric power J generated in a single process of stretching and shrinkage, the following procedures A to C will be contemplated:

A. The capacitance C1 in the stretched state is increased. For this purpose, it is contemplated that a dielectric elastomer layer having a high relative permittivity is employed, the thickness t1 in the stretched state is decreased and the electrode area A1 is increased.

B. The ratio C1/C2 of the capacitance in the stretched state to the capacitance in the shrunk state is increased. In other words, it is contemplated that a higher degree of stretching is applied to the power generating element to increase a change of the thickness. C. The bias voltage V1 is increased.

However, the aforementioned conventional power generating elements have only a pair of electrodes, and therefore sufficient electric power cannot be generated even if a procedure like the aforementioned procedures A to C is applied. Moreover, in order to attain the stretching, a member for gripping a sheet-shaped end portion of the power generating element is needed; in this case, a stress may converge on the gripping portion, leading to a failure of the electrode layer or the like.

It is to be noted that Japanese Unexamined Patent Application, Publication No. 2010-263750 discloses an example in which a sheet is formed into a roll. However, when the rolled sheet is stretched along an axis center direction, a distance between the electrode layers of a central portion is reduced, resulting in a failure to properly inhibit occurrence of a dielectric breakdown.

Moreover, Japanese Unexamined Patent Application, Publication No. 2010-263750 also discloses a power generating device in which a sheet having a three-layer structure constituted with a pair of electrode layers and a dielectric elastomer layer are laminated, as mentioned above, and other dielectric elastomer layer and other electrode layer are further laminated thereon. In this instance, three electrode layers are to be formed, and these are to be electrically connected such that, for example, the electrode layer on the front face side and the electrode layer on the back face side have a potential to exhibit a polarity different from that of the central electrode layer. Accordingly, if the number of the electrode layers and the dielectric elastomer layers are increased for the purpose of increasing the generated electric power, an electrical connection (wiring) therebetween is likely to be difficult.

[PRIOR ART DOCUMENTS]

[PATENT DOCUMENTS]

Patent Document 1: Japanese Unexamined Patent Application, Publication No. 2011-103713
Patent Document 2: Japanese Unexamined Patent Application, Publication No. 2010-57321
Patent Document 3: Japanese Unexamined Patent Application (Translation of PCT Application), Publication No. 2003-505865
Patent Document 4: Japanese Unexamined Patent Application, Publication No. 2010-263750

[SUMMARY OF THE INVENTION]

[PROBLEMS TO BE SOLVED BY THE INVENTION]

The present invention was made in view of the foregoing circumstances, and an object of the present invention is to provide a piezoelectric element that enables superior piezoelectric effects (a sufficient contractile force as an actuator element, and a larger amount of generated electric power as a power generating element) to be attained while having a comparatively simple structure and being easy to produce. Moreover, another object of the present invention is to provide a flexible sheet that enables the above-mentioned piezoelectric element to be easily produced.

[MEANS FOR SOLVING THE PROBLEMS]

The present invention was made for solving the aforementioned problems, and according to an aspect of the present invention, a piezoelectric element includes:

a plurality of strip-shaped flexible sheets having:

a dielectric elastomer layer; and
an electrode layer that is stretchable and laminated on the dielectric elastomer layer,

the plurality of flexible sheets being superposed crosswise on each other and alternately folded in an accordion shape such that the flexible sheets are alternately stacked.

The piezoelectric element has a structure in which on one face of an electrode layer of one flexible sheet, an electrode layer of other flexible sheet is overlaid via the dielectric elastomer layer, and the electrode layer of the one flexible sheet that has been folded back is overlaid on the other face of the electrode layer of the other flexible sheet via the dielectric elastomer layer.

Accordingly, for example, when the piezoelectric element is used as an actuator element, an electrostatic force is generated between the electrode layers by applying a voltage to each flexible sheet (hereinafter, may be referred to as "voltage applied state"). Then, the dielectric layer and the electrode layer are stretched in a planar direction by the electrostatic force, and the flexible sheet is shrunk along a direction of the thickness of the layer. Accordingly, a shrunk state can be attained in the voltage applied state. Moreover, when the applied voltage is eliminated (hereinafter, may be referred to as "voltage non-applied state"), the dielectric layer and the electrode layer are shrunk in a planar direction, and the flexible sheet is stretched along a direction of the thickness of the layer. Accordingly, a stretched state can be attained in the voltage non-applied state.

On the other hand, in the case of the use of the piezoelectric element as a power generating element, for example, when a load is applied to the overlaid portion of the electrode layer and the dielectric elastomer layer is compressed along a direction of the thickness of the layer, the dielectric layer and the electrode layer are stretched in a planar direction. Then, when the load applied to the overlaid portion is eliminated, the overlaid portion is restored due to elastic resilience of the dielectric elastomer layer, i.e., the overlaid portion is expanded along a direction of the thickness of the layer. The compression and expansion of the overlaid portion alters a distance between the electrode layers, resulting in a change of a capacitance, and electric power can be generated by utilizing the change of the capacitance. Moreover, since the power generating element generates electric power by way of the compression and expansion of the overlaid portion of the flexible sheets, as mentioned above, it is not necessary to grip the flexible sheet, unlike conventional power generating elements that generate electric power through expansion and contraction thereof, and therefore the flexible sheets is unlikely to be deteriorated. Moreover, as compared with the conventional power generating devices that generate electric power through the expansion and contraction thereof, the distance between the electrode layers upon compression is more likely to be more constant along a planar direction, and therefore a dielectric breakdown is less likely to occur. Since the power generating element has the aforementioned structure and includes at least four electrode layers that are stacked, a larger amount of electric power can be generated as compared with the conventional power generating devices.

Moreover, since the piezoelectric element has a simple structure in which a plurality of flexible sheets are superposed crosswise on each other and alternately folded in an accordion shape such that the flexible sheets are alternately stacked, as mentioned above, the piezoelectric element can be easily produced. In particular, the flexible sheets having the electrode layer is to be folded and a plurality of electrodes are to be provided from a single electrode layer, and therefore a wiring to each electrode is unnecessary unlike the conventional actuator elements and power generating elements, leading to a simple wiring structure.

Furthermore, since the piezoelectric element has a structure in which a plurality of flexible sheets are stacked on each other, the structure is simpler as compared with conventional actuator elements that have a gap between plate members. Furthermore, since the dielectric elastomer layer is disposed between the electrode layers, when the piezoelectric element is used as an actuator element, an electrostatic force exerted between the electrode layers can be increased and a sufficient contractile force can be attained.

When the piezoelectric element is used as an actuator element as mentioned above, it is preferred that at least one of the plurality of flexible sheets includes a pair of the dielectric layers laminated on front and back face sides of the electrode layer. Thus, the folding of the flexible sheet that has a structure in which the electrode layer is sandwiched between the pair of dielectric elastomer layers (hereinafter, may be referred to as "sandwich-structured flexible sheet") in an accordion shape reliably leads to the disposition of the dielectric elastomer layer of the sandwich-structured flexible sheet between the electrode layer of the sandwich-structured flexible sheet and the electrode layer of other flexible sheet.

Moreover, according to the actuator element, it is preferred that a pair of the flexible sheets are superposed on each other crosswise at substantially right angles and alternately folded in an accordion shape such that the flexible sheets are alternately stacked. More specifically, although in the actuator element, the pair of flexible sheets may be superposed on each other crosswise at an angle of, for example, 60°, in this case, the area of an overlapping region provided by superposing the pair of flexible sheets on each other shall be reduced. To the contrary, when the pair of flexible sheets are superposed on each other crosswise at substantially right angles, the area of an overlapping region provided by superposing the pair of flexible sheets on each other can be increased, leading to a larger region in which deformation of the dielectric elastomer layer occurs. It is to be noted that a crossing angle of a pair of flexible sheets means an angle formed by the respective center lines of the pair of flexible sheets, and the term "substantially right angle" means no less than 80°, and preferably no less than 85°.

According to the actuator element, it is preferred that the pair of flexible sheets are stacked to give no less than 10 layers and no greater than 10,000 layers. More specifically, although in the actuator element, a four-layer structure (i.e., each flexible sheet gives two layers) in which the pair of flexible sheets are superposed crosswise on each other and alternately folded in an accordion shape such that the flexible sheets are alternately stacked may be employed, the four-layer structure may not be able to attain a sufficient contraction amount. To the contrary, when the pair of flexible sheets are stacked to give no less than 10 layers and no greater than 10,000 layers (i.e., no less than 5 layers and no greater than 5,000 layers of each flexible sheet are stacked), a sufficient contraction amount can be attained.

In the actuator element, the dielectric elastomer layer has an average thickness of preferably no less than 10 $\mu$m and no greater than 100 $\mu$m. Thus, the dielectric elastomer layer can be properly stretched in a planar direction, i.e., shrunk along a direction of the thickness of the layer.

In the actuator element, the average thickness of the electrode layer is preferably no greater than 1/10 of the average thickness of the dielectric elastomer layer. Thus, the ratio of the dielectric elastomer layer to the electrode layer (in terms of the thickness of the layer) can be increased, and the dielectric elastomer layer can be properly stretched in a planar direction, i.e., shrunk along a direction of the thickness of the layer.

Moreover, according to another aspect of the present invention, an actuator includes: the actuator element including the aforementioned structure; a first rigid member joined to one face side of the actuator element; and a second rigid member joined to the other face side of the actuator element.

In the actuator, the actuator element can be contracted along a direction of the thickness of the layer by applying a voltage to each flexible sheet, resulting in a reduction of a distance between the first rigid member and the second rigid member.

Moreover, it is preferred that the actuator includes a plurality of the actuator elements, the first rigid member is joined to one face side of the plurality of actuator elements, and the second rigid member is joined to the other face side of the plurality of actuator elements. Thus, a distance between the first rigid member and the second rigid member can be reduced by means of the plurality of actuator elements, and additionally, the first rigid member and the second rigid member can be inclined by bringing only one actuator element into a contracted state.

When the piezoelectric element is used as an actuator element as mentioned above, it is preferred that at least one of the plurality of flexible sheets includes a pair of the dielectric layers laminated on front and back face sides of the electrode layer. Thus, the folding of the sandwich-structured flexible sheet in an accordion shape reliably leads to the disposition of the dielectric elastomer layer of the sandwich-structured flexible sheet between the electrode layer of the sandwich-structured flexible sheet and the electrode layer of other flexible sheet.

Moreover, according to the power generating element, it is preferred that a pair of the flexible sheets are superposed on each other crosswise at substantially right angles and alternately folded in an accordion shape such that the flexible sheets are alternately stacked. More specifically, although in the power generating element, the pair of flexible sheets may be superposed crosswise at an angle of, for example, 60°, in this case, the area of an overlapping region provided by superposing the pair of flexible sheets on each other shall be decreased. To the contrary, when the pair of flexible sheets are superposed on each other crosswise at substantially right angles, the area of an overlapping region provided by superposing the pair of flexible sheets on each other can be increased, leading to a larger capacitance and a larger amount of electric power.

According to the power generating element, it is preferred that the pair of flexible sheets are stacked to give no less than 10 layers and no greater than 10,000 layers. More specifically, although in the power generating element, a four-layer structure (i.e., each flexible sheet gives two layers) in which the pair of flexible sheets are superposed crosswise on each other and alternately folded in an accordion shape such that the flexible sheets are alternately stacked may be employed, the four-layer structure may result in a failure to generate sufficient electric power. To the contrary, when the pair of flexible sheets are stacked to give no less than 10 layers and no greater than 10,000 layers (i.e., no less than 5 layer and no greater than 5,000 layers of each flexible sheet are stacked), sufficient electric power can be attained.

In the power generating element, the dielectric elastomer layer preferably has an average thickness of no less than 10 $\mu$m and no greater than 100 $\mu$m. Thus, the dielectric elastomer layer can be properly stretched in a planar direction, i.e., compressed along a direction of the thickness of the layer.

In the power generating element, the average thickness of the electrode layer is preferably no greater than 1/10 of the average thickness of the dielectric elastomer layer. Thus, the ratio of the dielectric elastomer layer to the electrode layer (in terms of the thickness of the layer) can be increased, and the dielectric elastomer layer can be properly stretched in a planar direction, i.e., compressed along a direction of the thickness of the layer.

Moreover, a power generating device according to still another aspect of the present invention includes: the power generating element having the aforementioned structure; a first rigid member joined to one face side of the power generating element; and a second rigid member joined to the other face side of the power generating element.

In the power generating device, the power generating element can be contracted along a direction of the thickness of the layer by applying a voltage to each flexible sheet, resulting in a reduction of a distance between the first rigid member and the second rigid member.

Moreover, it is preferred that the power generating device includes a plurality of the actuator elements, the first rigid member is joined to one face side of the plurality of power generating elements, and the second rigid member is joined to the other face side of the plurality of power generating elements. Thus, the distance between the first rigid member and the second rigid member can be reduced by means of the plurality of power generating elements, and additionally the first rigid member and the second rigid member can be inclined by bringing only one power generating element into a contracted state.

Moreover, according to yet still another aspect of the present invention, a strip-shaped flexible sheet is provided, including: a stretchable electrode layer; and a pair of dielectric elastomer layers laminated on front and back face sides of the electrode layer.

According to the flexible sheet, the piezoelectric element that exhibits the aforementioned advantages can be produced by, for example, superposing one strip-shaped flexible sheet crosswise on other strip-shaped flexible sheet and alternately folding the strip-shaped flexible sheets in an accordion shape such that the strip-shaped flexible sheets are alternately stacked.

It is to be noted that the phrases "average thickness of a dielectric elastomer layer" and "average thickness of an electrode layer" refer to a thickness in a voltage non-applied state in which a voltage is not applied to an electrode layer and in a load non-applied state in which a load is not applied to the overlaid portion (i.e., the overlaid portion is not compressed).

[EFFECTS OF THE INVENTION]

As explained in the foregoing, the piezoelectric element according to the present invention enables superior piezoelectric effects to be attained while having a comparatively simple structure and being easy to produce. Moreover, the flexible sheet according to the present invention can be easily produced while including the piezoelectric element that exhibits the aforementioned advantages.

[BRIEF DESCRIPTION OF THE DRAWINGS]

Fig. 1 is a partially simplified schematic front view of an actuator according to a first embodiment of the present invention;
Fig. 2 is a schematic plan view of an actuator element of the actuator shown in Fig. 1;
Fig. 3A is an enlarged schematic lateral view of a principal part of a flexible sheet of the actuator element shown in Fig. 2;
Fig. 3B is a schematic cross sectional front view of the flexible sheet of the actuator element shown in Fig. 2;
Fig. 4 is a schematic front end view illustrating a relationship of the pair of flexible sheets in the actuator element shown in Fig. 2;
Fig. 5 is a schematic front view of an actuator according to other first embodiment of the present invention, with a detailed structure of the actuator being omitted;
Fig. 6 is a schematic front view of an actuator according to another first embodiment of the present invention, with a detailed structure of the actuator being omitted;
Fig. 7 is an enlarged schematic cross sectional front view of a principal part of a flexible sheet according to still another first embodiment of the present invention, with details of the flexible sheet being enlarged;
Fig. 8 is a schematic front view of an actuator element according to yet still another first embodiment of the present invention;
Fig. 9 is a schematic front view of an actuator element according to even yet still another first embodiment of the present invention;
Fig. 10 is a graph illustrating a relationship between an applied voltage and a percent contraction in Example of the actuator according to the embodiment of the present invention.
Fig. 11 is a partially simplified schematic front view of a power generating device according to a second embodiment of the present invention;
Fig. 12 is a schematic plan view of a power generating element of the power generating device shown in Fig. 11;
Fig. 13 is a schematic front end view illustrating a relationship of the pair of flexible sheets in the power generating element shown in Fig. 12;
Fig. 14 is a schematic front view of a power generating device according to other second embodiment of the present invention, with a detailed structure of the power generating device being omitted;
Fig. 15 is a schematic front view of a power generating device according to another second embodiment of the present invention, with a detailed structure of the power generating device being omitted; and
Fig. 16 is a table illustrating a relationship between compressibility and a bias voltage as well as a generated energy in Example of the power generating device according to the embodiment of the present invention.

[DESCRIPTION OF EMBODIMENTS]

Hereinafter, preferred modes for carrying out the present invention will be explained with reference to the drawings.

First Embodiment

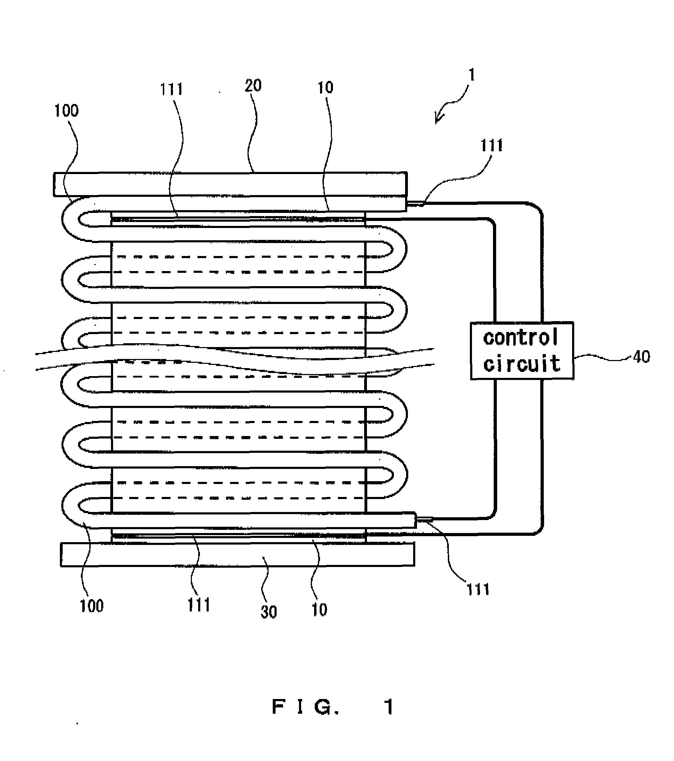

As a first embodiment of the piezoelectric element according to the present invention, an actuator element 10 for use in an actuator 1 shown in Fig. 1 will be explained first by way of an example.

Actuator 1

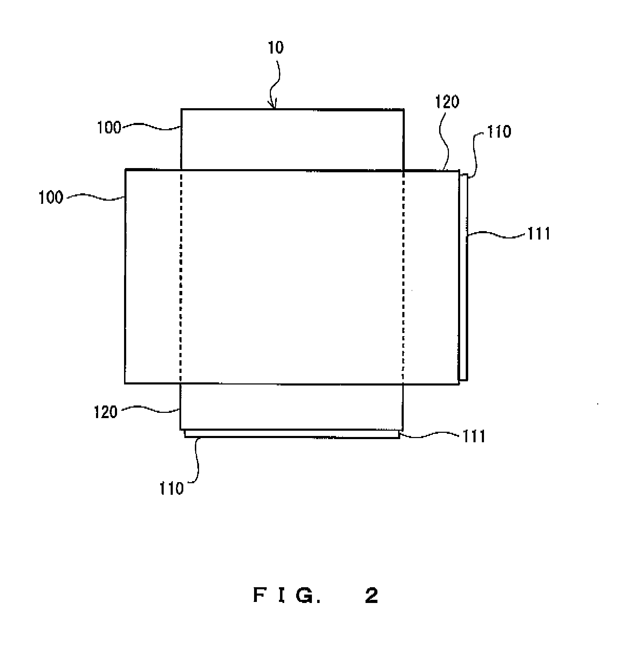

The actuator 1 shown in Fig. 1 includes an actuator element 10, a first rigid member 20 joined to one face side of the actuator element 10, and a second rigid member 30 joined to the other face side of the actuator element 10. In the illustrated embodiment, the first rigid member 20 and the second rigid member 30 are constituted with a plate member, and a contractable actuator element 10 is disposed between the first rigid member 20 and the second rigid member 30.
The actuator element 10 includes a plurality of flexible sheets 100 having an electrode layer 110 and a dielectric elastomer layer 120, as shown in Fig. 2, and the electrode layer 110 has a connection portion 111 protruding from an end of the flexible sheet 100. Moreover, the actuator 1 includes a control circuit 40 electrically connected to the electrode layer 110, as shown in Fig. 1. It is to be noted that a voltage is applied to the electrode layer 110 via the control circuit 40.

Actuator Element 10

In the actuator element 10, a plurality of strip-shaped flexible sheets 100 are folded such that the dielectric elastomer layer 120 is disposed between the electrode layers 110, 110. Specifically, a pair of flexible sheets 100 are superposed on each other crosswise at substantially right angles, and are alternately folded in an accordion shape such that the flexible sheets 100 are alternately stacked, as shown in Figs. 1 and 2. The pair of flexible sheets 100 have an identical structure.
Moreover, the pair of flexible sheets 100 are stacked to give preferably no less than 10 layers and no greater than 10,000 layers, more preferably no less than 30 layers and no greater than 1,000 layers, and still more preferably no less than 50 layers and no greater than 100 layers. When the number of layers is less than the above lower limit, the height of the actuator element 10 may be so low that a sufficient contraction amount may not be attained. When the number of layers is greater than the above upper limit, the length of the flexible sheet 100 may be so increased that defects may be generated in the flexible sheet 100, and further the defects may lead to a dielectric breakdown.

Flexible Sheet 100

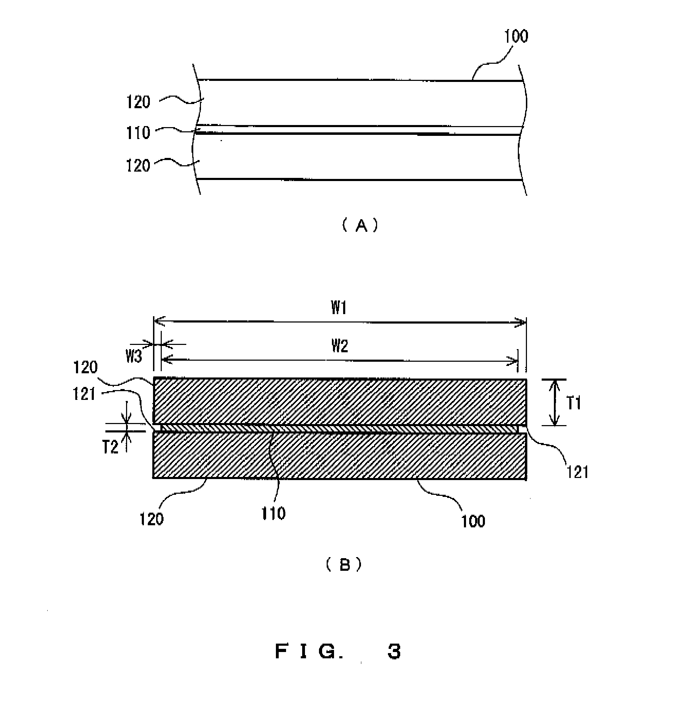

The flexible sheet 100 includes a stretchable electrode layer 110, and a pair of dielectric elastomer layers 120 laminated on front and back face sides of the electrode layer 110, as shown in Fig. 3. The pair of front and back dielectric elastomer layers 120 have an identical structure.
The flexible sheet 100 has an average thickness of preferably no less than 20 $\mu$m and no greater than 200 $\mu$m, and more preferably no less than 40 $\mu$m and no greater than 140 $\mu$m.
In addition, the width of the flexible sheet 100, i.e., the length along a lateral direction, may be appropriately modified in accordance with intended usages and the like of the actuator 1 employed, and may be 1 cm, for example. Furthermore, the length of the flexible sheet 100, i.e., the length along a longitudinal direction, may be appropriately modified in accordance with the times of superposition, the width of the sheet, and the like, and may be 80 cm, for example.
The dielectric layer 120 is an elastically deformable layer. The dielectric elastomer layer 120 may be made from natural rubber, isoprene rubber, nitrile rubber (NBR), ethylene propylene rubber (EPDM), styrene-butadiene rubber (SBR), butadiene rubber (BR), chloroprene rubber (CR), silicone rubber, fluorinated rubber, acrylic rubber, hydrogenated nitrile rubber, urethane rubber, or the like. In addition, the dielectric elastomer layer 120 is preferably made from hydrophobic rubber having superior dielectric strength and low hygroscopicity such as natural rubber, isoprene rubber, ethylene propylene rubber, butadiene rubber, silicone rubber and acrylic rubber. In particular, the dielectric layer 120 is preferably made from an elastomer having a polyrotaxane structure, in particular an elastomer having a hydrophobic polyrotaxane structure, such that an excessively large compressive deformation strain can be avoided when the elastic compressibility is reduced.
The dielectric layer 120 is formed with a substantially identical thickness to that of other dielectric elastomer layer 120. It is to be noted that the term "substantially identical thickness" means that a ratio of an average thickness of one dielectric elastomer layer 120 to an average thickness of other dielectric elastomer layer 120 is no less than 0.95 and no greater than 1.05.
The average thickness (T1) of the dielectric elastomer layer 120 (single layer) is preferably no less than 10 $\mu$m and no greater than 100 $\mu$m, more preferably no less than 20 $\mu$m and no greater than 70 $\mu$m, and particularly preferably no less than 30 $\mu$m and no greater than 50 $\mu$m. When the average thickness (T1) is less than the above lower limit, the dielectric elastomer layer 120 may be so thin that a dielectric breakdown of the dielectric elastomer layer 120 may be caused, and additionally an enormous number of flexible sheets 100 may be required to be stacked for the purpose of ensuring a sufficient height of the actuator element 10, i.e., the length along a direction of the thickness of the entire stacked flexible sheets, leading to an increase of a production cost. On the other hand, when the average thickness (T1) is greater than the above upper limit, the electrodes may be spaced too far away from each other when being stacked to be utilized as the actuator 1, resulting in low capacitance and an insufficient contractile force.

Moreover, the dielectric elastomer layer 120 has a compressive modulus of elasticity of preferably no less than 0.1 MPa and no greater than 1.5 MPa, and more preferably no less than 0.3 MPa and no greater than 0.7 MPa. When the compressive modulus of elasticity is less than the above lower limit, the dielectric elastomer layer 120 may be so soft that an excessively large compressive deformation strain may be caused. On the other hand, when the compressive modulus of elasticity is greater than the above upper limit, the dielectric elastomer layer 120 may be too rigid to be shrunk along a direction of the thickness of the layer. The compressive modulus of elasticity is determined under the application of a 10% strain in accordance with the compression test at low deformation described in JIS-K6254.

Furthermore, the relative permittivity of the dielectric elastomer layer 120 is preferably no less than 2 and no greater than 9, more preferably no less than 3 and no greater than 8, and still more preferably no less than 4 and no greater than 7. When the relative permittivity of the dielectric elastomer layer 120 is less than the above lower limit, the capacitance of the dielectric elastomer layer 120 may be reduced, leading to a difficulty to attain a sufficient contractile force when the dielectric elastomer layer 120 is utilized in the actuator 1. On the other hand, when the relative permittivity of the dielectric elastomer layer 120 is greater than the above upper limit, it is necessary to add a large amount of dielectric filler, and as a result, the dielectric elastomer layer may be so rigid that the deformation thereof may be unlikely to occur.

Moreover, the dielectric elastomer layer 120 is formed with a substantially identical width to that of other dielectric elastomer layer 120. It is to be noted that the term "substantially identical width" means that the ratio of the width of one dielectric elastomer layer 120 to the width of other dielectric elastomer layer 120 is no less than 0.95 and no greater than 1.05. The width (W1) of the dielectric elastomer layer 120 may be appropriately modified in accordance with intended usages and the like of the actuator 1 employed, and may be 1 cm, for example.

The electrode layer 110 is preferably made from an electrically conductive elastomer layer that is so stretchable as to be able to follow the stretching of the dielectric layer 120. The electrically conductive elastomer layer contains an electrically conductive filler in an elastomer. In this embodiment, an elastomer that can adhere to the dielectric elastomer layer 120 may be suitably used as the elastomer of the electrically conductive elastomer layer, and for example, the same elastomer component as that of the dielectric elastomer layer 120 may be used.

Moreover, the electrode layer 110 may be provided such that the electrode layer 110 is thinner than the dielectric elastomer layer 120, and the average thickness (T2) of the electrode layer 110 is preferably no less than 1/30 and no greater than 1/10, and more preferably no less than 1/20 and no greater than 1/15, of the average thickness (T1) of the dielectric elastomer layer 120 (single layer). When the average thickness (T2) of the electrode layer 110 is greater than the above upper limit, the proportion of the electrode layer 110 in the actuator element 10 (in terms of the thickness of the layer) may be increased, and the proportion of the dielectric elastomer layer 120 may be decreased, resulting in insufficient contraction of the actuator element 10. On the other hand, when the average thickness (T2) of the electrode layer 110 is less than the above lower limit, the electrically conductive elastomer layer may be so thin that the resistance of the electrode layer 110 may be increased.

Moreover, the average thickness (T2) of the electrode layer 110 is preferably no less than 50 nm and no greater than 50 $\mu$m, and more preferably no less than 1 $\mu$m and no greater than 10 $\mu$m. When the average thickness (T2) of the electrode layer 110 is greater than the above upper limit, the proportion of the electrode layer 110 in the actuator element 10 (in terms of the thickness of the layer) may be increased, and the proportion of the dielectric elastomer layer 120 may be decreased, resulting in insufficient contraction of the actuator element 10. On the other hand, when the average thickness (T2) of the electrode layer 110 is less than the above lower limit, the electrically conductive elastomer layer may be so thin that the resistance of the electrode layer 110 may be increased.

Furthermore, the electrode layer 110 has a compressive modulus of elasticity of preferably no less than 0.1 MPa and no greater than 1.5 MPa, and more preferably no less than 0.3 MPa and no greater than 0.7 MPa. When the compressive modulus of elasticity of the electrode layer 110 is less than the above lower limit, the electrode layer 110 may be so soft that an excessively large compressive deformation strain may be caused. On the other hand, when the compressive modulus of elasticity of the electrode layer 110 is greater than the above upper limit, the electrode layer 110 may be too rigid and the flexible sheet 100 may be difficult to be deformed. In such an electrode layer 110, application of a high voltage may be necessary for the deformation of the electrode layer 110, and the high voltage may cause a dielectric breakdown of the dielectric elastomer layer 120.

Moreover, the electrode layer 110 is formed with a width smaller than that of the dielectric elastomer layer 120. Specifically, the dielectric elastomer layer 120 includes a sleeve portion 121 extending outside of the electrode layer 110, leading to the inhibition of a short circuit and the like on an end face of the electrode layer 110. In this embodiment, the width of the sleeve portion 121 (W3 = (W1 - W2)/2) is preferably no less than 5 times and no greater than 100 times, and more preferably no less than 10 times and no greater than 50 times, of the average thickness (T2) of the electrode layer 110. Moreover, the width of the sleeve portion 121 is preferably no less than 1/100 times and no greater than 1/20 times, and more preferably no less than 1/50 times and no greater than 1/30 times, of the width (W1) of the dielectric elastomer layer 120. When the width of the sleeve portion 121 is less than the above lower limit, the effect of inhibiting a short circuit may not be sufficiently exhibited. On the other hand, when the width of the sleeve portion 121 is greater than the above upper limit, the width of the electrode layer 110 may be reduced, and in a planar view, the area of a region where the electrodes are superposed may be reduced, leading to a difficulty of attaining a sufficient contractile force.

The electrode layer 110 further includes, at the both ends of the flexible sheet 100, connection portions 111 protruding from the dielectric elastomer layer 120, and the actuator element 10 is electrically connected to other member (control circuit 40) through the connection portion 111. It is to be noted that the flexible sheet 100 is preferably folded back an odd number of times such that the connection portions 111 at the both ends are situated on the same side of the actuator element 10 (the right side, in Fig. 1).

Furthermore, various electrically conductive fillers may be employed as the electrically conductive filler of the electrode layer 110, and examples thereof include electrically conductive carbon blacks, carbon nanotubes (single-walled carbon nanotubes or multi-walled carbon nanotubes), electrically conductive metal fillers, and the like. In particular, a carbon nanotube having a large aspect ratio is preferably used as the electrically conductive filler of the electrode layer 110 in light of maintenance of the current-carrying property thereof even upon the stretching.

Method for Production of Flexible Sheet 100

The flexible sheet 100 can be produced using various methods. An example of the method for production of the flexible sheet 100 will be described bellow.

First, a material for forming a dielectric elastomer layer is applied through a procedure such as printing or coating to provide a layer, and the material for forming a dielectric elastomer layer is dried to form the dielectric elastomer layer 120. It is to be noted that the formation of the dielectric elastomer layer 120 can also be executed through an extrusion molding process, or the like.

A material for forming an electrode layer, which material contains a dispersed electrically conductive filler, is laminated on the front face of the dielectric elastomer layer 120 through a procedure such as printing or coating, thereafter other dielectric elastomer layer 120 is laminated on the front face of the laminated material for forming an electrode layer, and the material for forming an electrode layer is dried to form a flexible sheet 100 having a three-layer structure. It is to be noted that a process for dispersing the electrically conductive filler in the material for forming an electrode layer may be a solid phase dispersion process or a liquid phase dispersion process.

Advantages

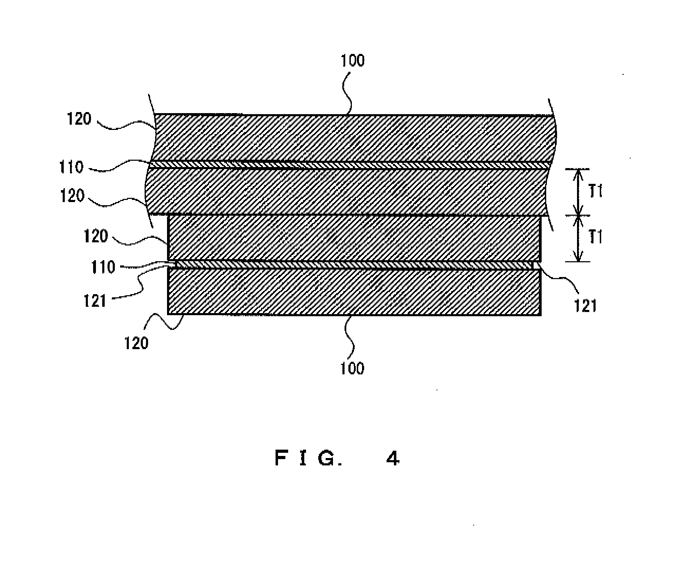

The actuator element 10 has a structure in which on the upper face of an electrode layer 110 of one lower flexible sheet 100, an electrode layer 110 of other flexible sheet 100 is overlaid via an upper dielectric elastomer layer 120 of the one flexible sheet 100 and a lower dielectric elastomer layer 120 of the other flexible sheet 100, as shown in Fig. 4. Accordingly, when a voltage is applied to the electrode layers 110 of the pair of flexible sheets 100, the dielectric elastomer layer 120 is stretched in a planar direction and consequently is shrunk along a direction of the thickness of the layer. An electrostatic force P generated in this process can be represented by the following equation:

$$P = \varepsilon_0 \times \varepsilon \times E^2$$

$$E = V/ (T1 + T1)$$

wherein $\varepsilon_0$ represents a permittivity of a free space; $\varepsilon$ represents a relative permittivity of the dielectric elastomer layer 120; E represents an electric field intensity between a pair of electrode layers 110; V represents a potential difference (applied voltage) between the pair of electrode layers 110; and T1 represents an average thickness of the dielectric elastomer layer 120.

On the other hand, when the applied voltage is eliminated, the dielectric elastomer layer 120 is shrunk in a planar direction, and the flexible sheet 100 is expanded along a direction of the thickness of the layer. In other words, the dielectric elastomer layer 120 is restored.

Thus, an expanded state can be attained in the voltage non-applied state and a contracted state can be attained in the voltage applied state.

The actuator 1 has a simple structure in which the pair of flexible sheets 100 are superposed crosswise and alternately folded in an accordion shape such that the flexible sheets 100 are alternately stacked, and therefore can be easily produced, as mentioned above. In particular, the flexible sheet 100 having an electrode layer 110 is to be folded and a plurality of electrodes are to be provided from a single electrode layer 110, and therefore, unlike the conventional actuator element 10, a wiring to each electrode is unnecessary, leading to a simple wiring structure.

Furthermore, since the actuator 1 has a structure in which a plurality of flexible sheets 100 are stacked on each other, the structure is simpler as compared with a conventional actuator that has a gap between plate members. Furthermore, since the dielectric elastomer layer 12C is disposed between the electrode layers 110, an electrostatic force exerted between the electrode layers 110 can be increased and a sufficient contractile force can be attained.

Furthermore, since the actuator 1 includes a flexible sheet 100 having a three-layer structure in which a pair of dielectric elastomer layers 120 are laminated on the front and back face sides of the electrode layer 110, the folding of the flexible sheet 100 in an accordion shape reliably leads to the disposition of the dielectric elastomer layer 120 of the flexible sheet 100 between the electrode layers 110 of the pair of flexible sheets 100, and therefore the actuator 1 can be easily produced.

Moreover, according to the actuator 1, the pair of flexible sheets 100 are superposed on each other crosswise at substantially right angles, and therefore the area of an overlapping region provided by superposing the pair of flexible sheets 100 on each other can be increased, and a region in which the deformation of the dielectric elastomer layer 120 occurs can be increased, leading to a larger contraction amount and a sufficient contractile force.

Modifications of Above-Described Actuator, Actuator Element and Flexible Sheet (Other First Embodiments)

It is to be noted that in addition to the aforementioned first embodiment, the present invention can be carried out in various modes with alterations and/or improvements being made.

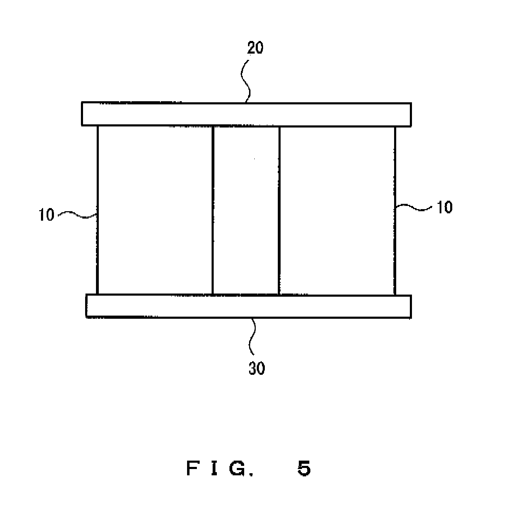

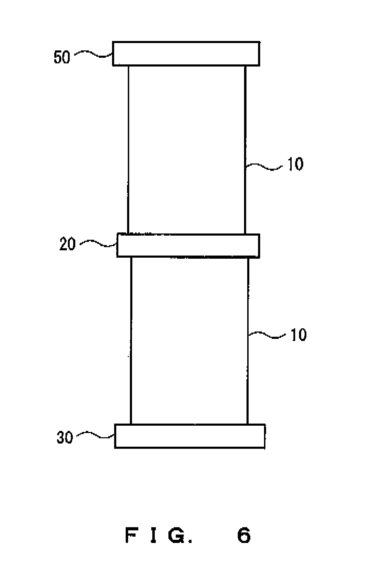

Specifically, although in the aforementioned embodiment, the actuator including one actuator has been explained, the actuator may be appropriately modified such that the actuator includes a plurality of actuator elements 10, 10. More specifically, a structure in which the first rigid member 20 is joined to one face side (upper face side) of a plurality of (two, in the embodiment shown) actuator elements 10, 10, and the second rigid member 30 is joined to the other face side (lower face side) of the plurality of actuator elements 10, 10, as shown in Fig. 5, may be employed. Furthermore, a structure in which a first rigid member 20, a second rigid member 30 and a third rigid member 50 are included and arranged parallel to one another, and actuator elements 10, 10 are disposed between the first rigid member 20 and the second rigid member 30 and between the first rigid member 20 and the third rigid member 50, respectively, as shown in Fig. 6, may be employed.

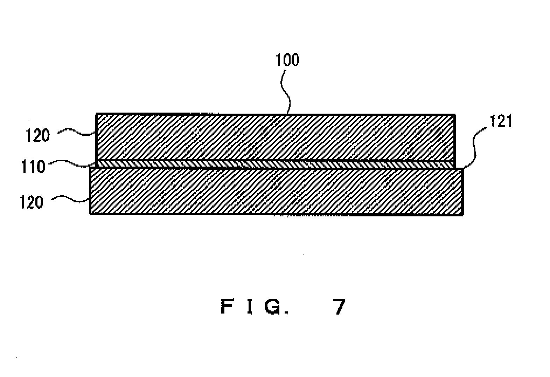

Moreover, although in the aforementioned embodiment, the actuator that includes a pair of dielectric elastomer layers 120 having an identical width has been explained, the present invention is not limited thereto; an actuator that includes a pair of dielectric elastomer layers 120 having a different width falls within a scope contemplated by the present invention. Furthermore, even in this instance, it is preferred that at least one of the pair of dielectric elastomer layers 120 is provided so as to be wider than the electrode layer 110 and to have a sleeve portion 121 extending outside of the electrode layer 110. Specifically, for example, a structure in which the dielectric elastomer layer 120 on one face of electrode layer 110 has a width identical to that of the electrode layer 110, and the dielectric elastomer layer 120 on the other face of electrode layer 110 has a width wider than that of the electrode layer 110, accompanied by the sleeve portion 121, as shown in Fig. 7, may be employed. It is to be noted that in the production of the flexible sheet 100, a method for production may be employed in which a material for forming an electrode layer 110 is laminated on the front face of the dielectric elastomer layer 120 having a wider width, then the laminated material for forming an electrode layer 110 is dried to form an electrode layer 110, thereafter a material for forming a dielectric elastomer layer 120 is laminated on the front face of the electrode layer 110, and then the laminated material for forming a dielectric elastomer layer 120 is dried to form a dielectric elastomer layer 120 having an identical width.

Moreover, although in the aforementioned embodiment, the actuator that includes a pair of dielectric elastomer layers 120 having an identical thickness has been explained, the present invention is not limited thereto; an actuator that includes a pair of dielectric elastomer layers 120 having a different thickness falls within a scope contemplated by the flexible sheet 100 according to the present invention. It is to be noted that in this instance, a sum of the average thickness of the pair of dielectric layers 120 is preferably no less than 20 $\mu$m and no greater than 200 $\mu$m, more preferably no less than 40 $\mu$m and no greater than 140 $\mu$m, and particularly preferably no less than 60 $\mu$m and no greater than 100 $\mu$m. When the sum of the average thickness of the pair of dielectric layers 120 is less than the above lower limit, the dielectric elastomer layer 120 may be so thin that a dielectric breakdown of the dielectric elastomer layer 120 may be caused, and additionally an enormous number of flexible sheets 100 may be required to be stacked for the purpose of ensuring a sufficient height, i.e., the length along a stacking direction, of the actuator element 10, leading to an increase of a production cost. On the other hand, when the sum of the average thickness of the pair of dielectric layers 120 is greater than the above upper limit, the electrodes may be spaced too far away from each other when being superposed, resulting in low capacitance and an insufficient contractile force.

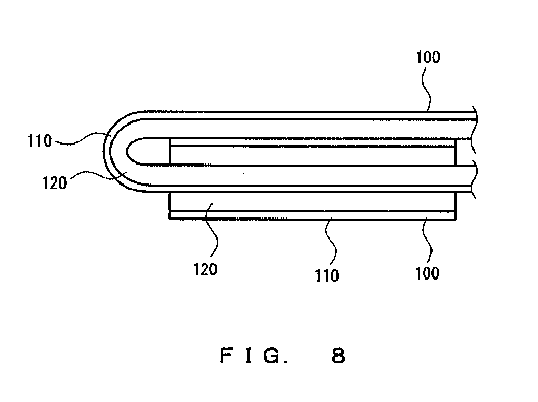

Furthermore, although in the aforementioned embodiment, an example in which the flexible sheets 100 are stacked to form a multilayer has been explained, the actuator element 10 according to the embodiment of the present invention may have a structure in which a pair of flexible sheets 100 are folded once and superposed crosswise on each other and alternately folded in an accordion shape such that the flexible sheets 100 are alternately stacked, and consequently four layers of the flexible sheet 100 in total are included, as shown in Fig. 8.

Moreover, although in the aforementioned embodiment, the flexible sheet 100 having a three-layer structure has been explained, the present invention is not limited thereto. For example, a flexible sheet 100 that has a two-layer structure constituted with an electrode layer 110 and a dielectric elastomer layer 120, as shown in Fig. 8, may be used as the actuator element 10 according to the embodiment of the present invention. The actuator element 10 shown in Fig. 8 has a structure in which each flexible sheet 100 is folded once, and is superposed on each other and alternately folded in an accordion shape such that the flexible sheets 100 are alternately stacked so as to inhibit the contact of electrode layers 110 with each other. However, the flexible sheet preferably has a three-or-more-layer structure in which an electrode layer and a pair of dielectric elastomer layers laminated on front and back face sides of the electrode layer are included; in such a structure, a short circuit between the electrode layers can be easily inhibited, enabling the actuator element to be produced easily.

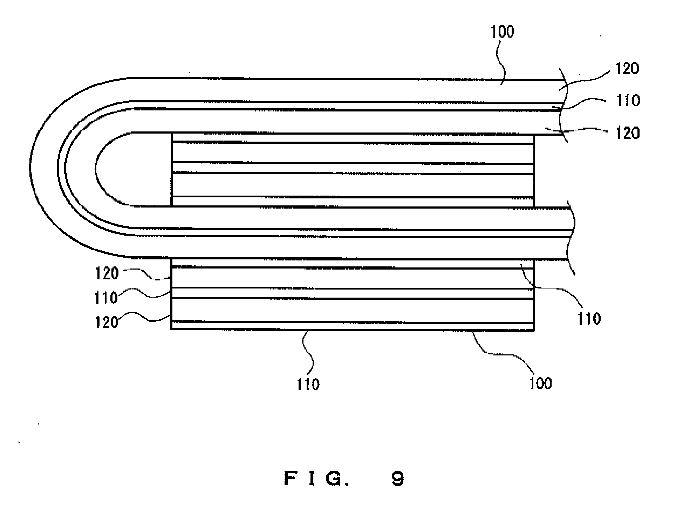

Furthermore, a flexible sheet 100 having a four-or-more-layer structure may be employed. Specifically, a flexible sheet 100 having a five-layer structure in which an electrode layer 110, a dielectric elastomer layer 120, another electrode layer 110, another dielectric elastomer layer 120, and still another electrode layer 110 are laminated in this order, as shown in Fig. 9, may be employed. However, in the flexible sheet, the dielectric elastomer layer is preferably provided as an outermost layer, i.e., the frontmost layer and the rearmost layer; in such a structure, a short circuit of the electrode layer can be properly inhibited.

Moreover, although the embodiment in which the pair of flexible sheets 100 having an identical structure are included has been explained above, the present invention is not limited thereto; the embodiment may be appropriately modified such that a pair of flexible sheets 100 are constituted with flexible sheets 100 having a different structure, as shown in Fig. 9 as described above.

Furthermore, although in connection with the aforementioned embodiment, the flexible sheet 100 has been explained, by way of example, as being for use in an actuator element and being intended to be used in the actuator element 10, the flexible sheet 100 according to the embodiment of the present invention is not limited thereto. More specifically, the flexible sheet 100 according to the embodiment of the present invention may be used in, for example, a power generating element and the like, as in a second embodiment as described later.

Furthermore, although the embodiment in which the pair of flexible sheets 100 are folded has been explained above, the present invention is not limited thereto, and for example, an actuator element in which two pairs of flexible sheets are folded may be employed. More specifically, an actuator element in which each flexible sheet is superposed on each other crosswise at about 45° and alternately folded in an accordion shape such that the flexible sheets are alternately stacked may be employed.

Moreover, although the embodiment in which the pair of flexible sheets 100 have an identical structure, and the flexible sheet 100 has a pair of front and back dielectric elastomer layers 120 has been explained above, the present invention is not limited thereto; the embodiment may be appropriately modified such that a flexible sheet having a different structure is employed or a flexible sheet that includes front and back dielectric elastomer layers having a different structure may be used. However, the outermost surfaces of the pair of flexible sheets are preferably constituted with a layer that is made from an identical material and that has self-tackiness; in such a structure, a shape of an actuator element having the stacked structure is likely to be retained without an adhesive.

Example 1

Hereinafter, the present invention will be explained in more detail by way of Example, but the present invention is not limited to the following Example.

Example

The flexible sheet used in this Example had a three-layer structure constituted with an electrode layer 110 having an average thickness of 10 $\mu$m and two dielectric elastomer layers each having an average thickness of 45 $\mu$m and laminated on a front face and a back face of the electrode layer 110.

The dielectric layer was provided using a forming material prepared by adding 30 parts by mass of a plasticizer to 100 parts by mass of ESPRENE (trade name) (manufactured by Sumitomo Chemical Co., Ltd.), and further adding barium titanate having a mean particle diameter of 0.5 $\mu$m as a dielectric filler in an amount of 25% by volume with respect to the total volume. Moreover, the electrode layer was provided using a forming material prepared by adding 30 parts by mass of a plasticizer to 100 parts by mass of ESPRENE (trade name) (manufactured by Sumitomo Chemical Co., Ltd.), and further adding carbon nanotubes as an electrically conductive filler in an amount of 2.8% by volume with respect to the total volume. It is to be noted that the dielectric elastomer layer and the electrode layer were each used after crosslinking.

The dielectric layer had a relative permittivity of 6.5.

The hardness (Duro A) of the dielectric layer determined at 20 °C using a type A durometer in accordance with JIS-K6253 (the measurement was carried out in triplicate and an average value of the measurements was calculated) was 6. Moreover, the hardness (Duro C) of the dielectric layer determined at 20 °C using a type C durometer in accordance with JIS-K7312 "type C hardness test" was 32.

Further, an elongation modulus determined at an elongation of 10% (M10) of the flexible sheet was 0.01 MPa, an elongation modulus determined at an elongation of 50% (M50) was 0.07 MPa, an elongation modulus determined at an elongation of 100% (M100) was 0.12 MPa, and an elongation modulus determined at an elongation of 400% (M400) was 0.49 MPa. It is to be noted that the determination of the elongation modulus was carried out using a dumbbell-type test piece (JIS No. 3) in accordance with JIS-K7312.

The tensile strength of the flexible sheet determined in accordance with JIS-K6323, "8.2 tensile test" was 2.2 MPa, Moreover, the elongation at break of the flexible sheet determined in accordance with JIS-K6732 was 1,079%.

The compressive modulus of elasticity of the flexible sheet determined in accordance with the method A in JIS-K-6254 was 0.5 MPa. More specifically, a test piece having a thickness of $12.5 \pm 0.5$ mm and a diameter of $29.0 \pm 0.5$ mm was compressed at a rate of $10 \pm 1$ mm/min until a 25% strain was attained, and immediately thereafter, unloading was allowed at the same rate. This operation was further repeated three times, and a strain and a force were recorded. A compressive force at strains of 10% and 20% was determined based on the fourth curve, and a compressive modulus of elasticity was calculated according to the equation.

The dielectric strength for DC of the flexible sheet determined in accordance with JIS-C2110-1,2 was 37.4 kV/mm. In this determination, a voltage-elevation procedure, a short time test, a shape of the electrode of $\Phi$20 mm spherical/ $\Phi$25 mm flat plate, and a test thickness of no greater than 1 mm were involved.

An actuator element was produced by superposing a pair of the flexible sheets crosswise and alternately folding the same in an accordion shape. In this instance, each flexible sheet was alternately folded seven times, and an actuator element 10 was produced in which eight layers of each flexible sheet 100, i.e., sixteen layers in total, were stacked.

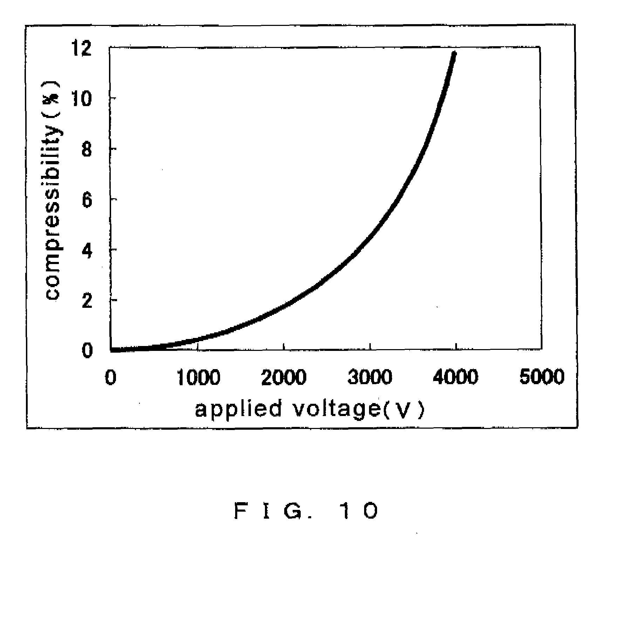

A voltage was applied to the electrode layer of the actuator element, and a contraction amount was determined. The results are shown in Fig. 10. In these determinations, a high voltage DC power supply manufactured by Matsusada Precision Inc. was used as an electric power supply, a laser displacement meter manufactured by OMRON Corporation was used for the determination of the contraction amount, and a data logging system NR-500 manufactured by Keyence Corporation was used for data storage.

As is clear from Fig. 10, the actuator element can be contracted upon application of a voltage, and can be expanded due to the resilience thereof upon elimination of the applied voltage.

Second Embodiment

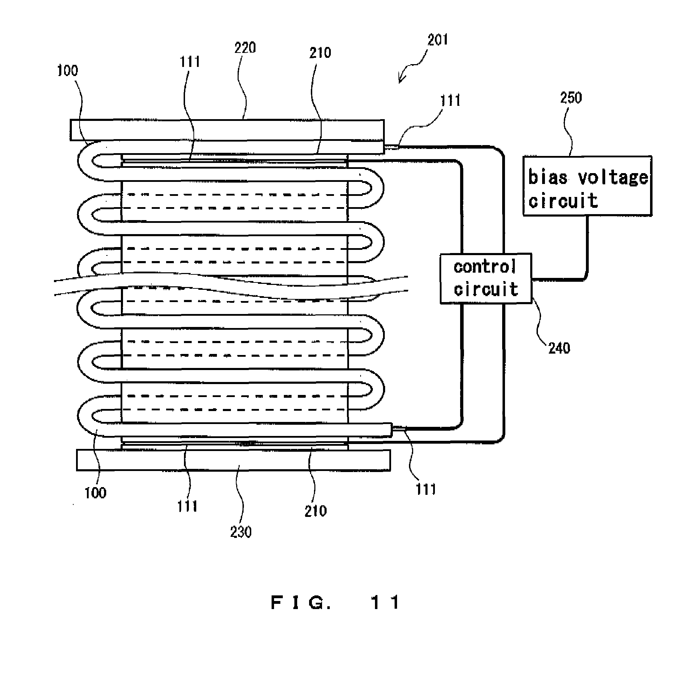

As a second embodiment of the piezoelectric element according to the present invention, a power generating element 210 for use in a power generating device 201 as shown in Figs. 11 to 13 will be explained first by way of an example.

Hereinafter, embodiments of the present invention will be explained with reference to the drawings.

Power Generating Device 201

A power generating device 201 shown in Fig. 11 includes: a power generating element 210 that includes a flexible sheet 100 being for use in a power generating element and having a structure identical to that of the first embodiment; a first rigid member 220 joined to one face side of the power generating element 210; and a second rigid member 230 joined to the other face side of the power generating element 210, In the illustrated embodiment, the first rigid member 220 and the second rigid member 230 are constituted with a plate member, and a contractable power generating element 210 is disposed between the first rigid member 220 and the second rigid member 230.

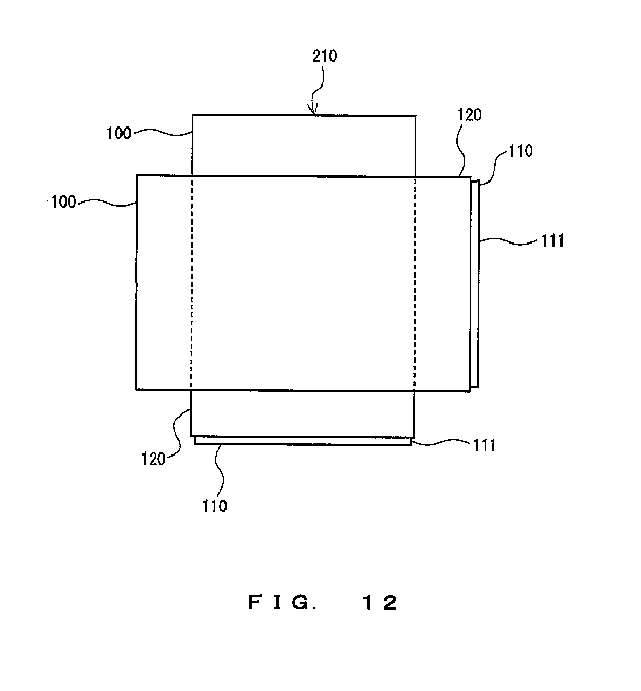

The power generating element 210 includes a plurality of flexible sheets 100 having an electrode layer 110 and a dielectric elastomer layer 120, and the electrode layer 110 includes a connection portion 111 protruding from an end of the flexible sheet 100, as shown in Fig. 12. In addition, the power generating device 201 includes a control circuit 240 electrically connected to the electrode layer 110, as shown in Fig. 11. Moreover, the power generating device 201 includes a bias voltage circuit 250 for applying a bias voltage to the control circuit 240. In the electrode layer 110, a bias voltage is applied via the control circuit 240, and the electric power generated in the power generating element 210 is taken out via the control circuit 240.

Power Generating Element 210

In the power generating element 210, a plurality of strip-shaped flexible sheets 100 is folded such that the dielectric elastomer layer 120 is disposed between the electrode layers 110, 110. Specifically, a pair of flexible sheets 100 are superposed on each other crosswise at substantially right angles, and alternately folded in an accordion shape such that the flexible sheets 100 are alternately stacked, as shown in Figs. 11 and 12. The pair of flexible sheets 100 have an identical structure.

Moreover, the pair of flexible sheets 100 are stacked to give preferably no less than 10 layers and no greater than 10,000 layers, more preferably no less than 30 layers and no greater than 1,000 layers, and still more preferably no less than 50 layers and no greater than 100 layers. When the number of the layers is less than the above lower limit, the flexible sheet 100 may be difficult to be stretched in a planar direction upon compression, resulting in a failure to generate sufficient electric power. When the number of the layers is greater than the above upper limit, the length of the flexible sheet 100 may be so increased that defects may be generated in the flexible sheet 100, and further the defects may lead to a dielectric breakdown.

Flexible Sheet 100

In the power generating element 210, as the flexible sheet 100, the same flexible sheet as that in the first embodiment may be used, as mentioned above. In other words, the flexible sheet 100 includes a stretchable electrode layer 110; and a pair of dielectric elastomer layers 120 laminated on front and back face sides of the electrode layer 110, as shown in Fig. 3. The pair of front and back dielectric elastomer layers 120 have an identical structure.

The flexible sheet 100 in the power generating element 210 also has an average thickness of preferably no less than 20 $\mu$m and no greater than 200 $\mu$m, and more preferably no less than 40 $\mu$m and no greater than 140 $\mu$m. Moreover, the width of the flexible sheet 100, i.e., the length along a lateral direction, may be appropriately modified in accordance with intended usages of the power generating device 201 employed, and the like, and may be 1 cm, for example. Furthermore, the length of the flexible sheet 100, i.e., the length along a longitudinal direction, may be appropriately modified in accordance with the times of superposition, the width of the sheet, and the like, and may be 80 cm, for example.

Also in the power generating element 210, the dielectric layer 120 is an elastically deformable layer, and a material of the dielectric elastomer layer 120 may be identical to that of the dielectric elastomer layer 120 of the first embodiment; therefore, explanation of the dielectric layer 120 will be omitted.

The dielectric layer 120 is formed with a substantially identical thickness to that of other dielectric elastomer layer 120. It is to be noted that the term "substantially identical thickness" means the ratio of the average thickness of one dielectric elastomer layer 120 to the average thickness of other dielectric elastomer layer 120 is no less than 0.95 and no greater than 1.05.

The average thickness (T1) of the dielectric elastomer layer 120 (single layer) is preferably no less than 10 $\mu$m and no greater than 100 $\mu$m, more preferably no less than 20 $\mu$m and no greater than 70 $\mu$m, and particularly preferably no less than 30 $\mu$m and no greater than 50 $\mu$m. When the average thickness (T1) is less than the above lower limit, the dielectric elastomer layer 120 may be so thin that a dielectric breakdown of the dielectric elastomer layer 120 may be caused, and additionally an enormous number of flexible sheets 100 may be required to be stacked for the purpose of ensuring a sufficient height of the power generating element 210, i.e., the length along a direction of the thickness of the entire stacked flexible sheets, leading to an increase of a production cost. On the other hand, when the average thickness (T1) is greater than the above upper limit, the electrodes may be spaced too far away from each other when being stacked to be utilized as the power generating device 201, resulting in low capacitance and less electric power.

Moreover, the dielectric elastomer layer 120 has a compressive modulus of elasticity of preferably no less than 0.1 MPa and no greater than 1.5 MPa, and more preferably no less than 0.3 MPa and no greater than 0.7 MPa. When the compressive modulus of elasticity is less than the above lower limit, the dielectric elastomer layer 120 may be so soft that an excessively large compressive deformation strain may be caused. On the other hand, when the compressive modulus of elasticity is greater than the above upper limit, the dielectric elastomer layer 120 may be so rigid that the dielectric elastomer layer 120 may be difficult to be compressed along a direction of the thickness of the layer. The compressive modulus of elasticity is determined under the application of a 10% strain in accordance with the compression test at low deformation described in JIS-K6254.

Furthermore, the relative permittivity of the dielectric elastomer layer 120 is preferably no less than 2 and no greater than 9, more preferably no less than 3 and no greater than 8, and still more preferably no less than 4 and no greater than 7. When the relative permittivity of the dielectric elastomer layer 120 is less than the above lower limit, the capacitance may be reduced, resulting in a failure to generate sufficient electric power when the dielectric elastomer layer 120 is utilized in the power generating device 201. On the other hand, when the relative permittivity is greater than the above upper limit, it is necessary to add a large amount of dielectric filler, and as a result, the dielectric elastomer layer may be so rigid that the deformation thereof may be unlikely to occur.

Moreover, the dielectric elastomer layer 120 is formed with a substantially identical width to that of other dielectric elastomer layer 120. It is to be noted that the term "substantially identical width" means that the ratio of the width of one dielectric elastomer layer 120 to the width of other dielectric elastomer layer 120 is no less than 0.95 and no greater than 1.05. The width (W1) of the dielectric elastomer layer 120 may be appropriately modified in accordance with intended usages and the like of the power generating device 201 employed, and may be 1 cm, for example.

The electrode layer 110 is preferably made from an electrically conductive elastomer layer that is so stretchable as to be able to follow the stretching of the dielectric layer 120. The electrically conductive elastomer layer contains an electrically conductive filler in an elastomer. In this embodiment, an elastomer that can adhere to the dielectric elastomer layer 120 may be suitably used as the elastomer of the electrically conductive elastomer layer, and for example, the same elastomer component as that of the dielectric elastomer layer 120 may be used.

Moreover, the electrode layer 110 may be provided such that the electrode layer 110 is thinner than the dielectric elastomer layer 120, and the average thickness (T2) of the electrode layer 110 is preferably no less than 1/30 and no greater than 1/10, and more preferably no less than 1/20 no greater than 1/15, of the average thickness (T1) of the dielectric elastomer layer 120 (single layer). When the average thickness (T2) is greater than the above upper limit, the proportion of the electrode layer 110 in the power generating element 210 (in terms of the thickness of the layer) may be increased, and the proportion of the dielectric elastomer layer 120 may be decreased, resulting in a failure to generate sufficient electric power by means of the power generating element 210. On the other hand, when the average thickness (T2) is less than the above lower limit, the electrically conductive elastomer layer may be so thin that the resistance of the electrode layer 110 may be increased.

Moreover, the average thickness (T2) of the electrode layer 110 is preferably no less than 50 nm and no greater than 50 $\mu$m, and more preferably no less than 1 $\mu$m and no greater than 10 $\mu$m. When the average thickness (T2) is greater than the above upper limit, the proportion of the electrode layer 110 in the power generating element 210 (in terms of the thickness of the layer) may be increased, and the proportion of the dielectric elastomer layer 120 may be decreased, resulting in a failure to generate sufficient electric power by means of the power generating element 210. On the other hand, when the average thickness (T2) is less than the above lower limit, the electrically conductive elastomer layer may be so thin that the resistance of the electrode layer 110 may be increased.

Furthermore, the electrode layer 110 has a compressive modulus of elasticity of preferably no less than 0.1 MPa and no greater than 1.5 MPa, and more preferably no less than 0.3 MPa and no greater than 0.7 MPa. When the compressive modulus of elasticity is less than the above lower limit, the electrode layer 110 may be so soft that an excessively large compressive deformation strain may be caused. On the other hand, when the compressive modulus of elasticity is greater than the above upper limit, the electrode layer 110 may be too rigid and may not be able to follow the dielectric elastomer layer 120.

Moreover, the electrode layer 110 is formed with a width smaller than that of the dielectric elastomer layer 120. Specifically, the dielectric elastomer layer 120 includes a sleeve portion 121 extending outside of the electrode layer 110, leading to the inhibition of a short circuit and the like on an end face of the electrode layer 110. In this embodiment, the width of the sleeve portion 121 (W3 = (W1 - W2)/2) is preferably no less than 5 times and no greater than 100 times, and more preferably no less than 10 times and no greater than 50 times, of the average thickness (T2) of the electrode layer 110. Moreover, the width of the sleeve portion 121 is preferably no less than 1/100 times and no greater than 1/20 times, and more preferably no less than 1/50 times and no greater than 1/30 times, of the width (W1) of the dielectric elastomer layer 120. When the width of the sleeve portion 121 is less than the above lower limit, the effect of inhibiting a short circuit may not be sufficiently exhibited. On the other hand, when the width of the sleeve portion 121 is greater than the above upper limit, the width of the electrode layer 110 may be reduced, and in a planar view, the area of a region where the electrodes are superposed may be reduced, leading to a difficulty of attaining a sufficient contractile force.

The electrode layer 110 further includes, at the both ends of the flexible sheet 100, connection portions 111 protruding from the dielectric elastomer layer 120, and the power generating element 210 is electrically connected to other member (control circuit 240) via the connection portion 111. It is to be noted that the flexible sheet 100 is preferably folded back an odd number of times such that the connection portions 111 at the both ends are situated on the same side of the power generating element 210 (the right side, in Fig. 1).

Furthermore, various electrically conductive fillers may be employed as the electrically conductive filler of the electrode layer 110, and the same electrically conductive filler as that described in the first embodiment may be employed as the electrically conductive filler in the second embodiment; therefore, a detailed explanation thereof will be omitted.

Advantages

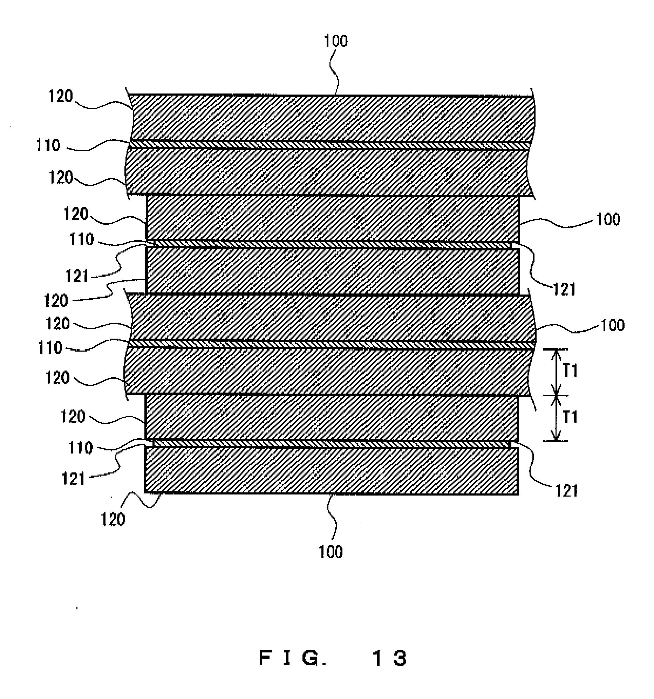

As shown in Fig. 13, the power generating element 210 has a structure in which, when explained starting from the lower part thereof, on the upper face of an electrode layer 110 of one flexible sheet 100, an electrode layer 110 of other flexible sheet 100 is overlaid via an upper dielectric elastomer layer 120 of the one flexible sheet 100 and a lower dielectric elastomer layer 120 of the other flexible sheet 100. In addition, the electrode layer 110 of the one flexible sheet 100 that has been folded back is overlaid on the upper face of the electrode layer 110 of the other flexible sheet 100 via the upper dielectric elastomer layer 120 of the other flexible sheet 100 and the lower dielectric elastomer layer 120 of the one flexible sheet 100 that has been folded back as mentioned above. Furthermore, the electrode layer 110 of the other flexible sheet 100 that has been folded back is overlaid on the upper face of the electrode layer 110 of the one flexible sheet 100 that has been folded back via the upper dielectric elastomer layer 120 of the one flexible sheet 100 that has been folded back and the lower dielectric elastomer layer 120 of the other flexible sheet 100 that has been folded back. Accordingly, the power generating element 210 is compressed along a direction of the thickness of the layer by applying a bias voltage to the electrode layers 110 of the pair of flexible sheets 100, and additionally applying a load of (or pressing) the overlaid portion of the flexible sheets 100 (the superposed portion) . Then, when the load applied on the overlaid portion is eliminated, the power generating element 210 is restored due to elastic resilience of (the dielectric elastomer layer 120 and the electrode layer 110 of) the flexible sheet 100, i.e., expanded along a direction of the thickness of the layer. Upon the compression and expansion, the distance between the electrode layers is altered and consequently, the capacitance changes. Electric power can be generated by utilizing the change of the capacitance.

The electric power $\Delta J$ generated between one electrode layer 110 and the other electrode layer 110 facing the one electrode layer 110 across the dielectric elastomer layer 120 is represented by the following equation (7) :

$$\Delta J = (1/2) \times \Delta C1 \times V1^2 \times (\Delta C1/\Delta C2 - 1) \cdots \text{equation (7)}$$

wherein $\Delta C1$ represents a capacitance in an expanded state ; $\Delta C2$ represents a capacitance in a compressed state; and V1 represents a bias voltage applied in the compressed state.

Moreover, the capacitances $\Delta C1$ and $\Delta C2$ are represented by the following equations (8) and (9), respectively :

$$\Delta C1 = \varepsilon_0 \times \varepsilon \times A1/2T1 = \varepsilon_0 \times \varepsilon \times b1/4T1^2 \cdots \text{equation (8)}$$

$$\Delta C2 = \varepsilon_0 \times \varepsilon \times A2/2T1' = \varepsilon_0 \times \varepsilon \times b2/4T1'^2 \cdots \text{equation (9)}$$

wherein $\varepsilon_0$ represents a permittivity of a free space; $\varepsilon$ represents a relative permittivity of the dielectric elastomer layer; A1 represents an electrode area in the expanded state; T1 represents a thickness of the dielectric elastomer layer 120 in the expanded state; b1 represents a volume of a space between the electrodes in the expanded state and is a product of A1 and twice the T1 (i.e., b1 = A1 x 2T1); moreover, A2 represents an electrode area in the compressed state; T1' represents a distance between the electrodes (the thickness of the dielectric elastomer layer) in the compressed state; and b2 represents a volume of a space between the electrodes (a volume of the dielectric elastomer layer) in the compressed state and is a product of A2 and twice the T1' (i.e., b2 = A2 x 2T1').

Assuming that the volume in the compressed state and the volume in the contracted state are the same (i.e., b1 = b2), the respective capacitances $\Delta C1$ and $\Delta C2$ satisfy the following equation (10) :

$$\Delta C1/\Delta C2 = T1'^2/T1^2 \cdots \text{equation (10)}$$

Using the equations (10) and (8), the equation (7) can be rewritten as the following equation (11) :

$$\Delta J = (1/2) \times \varepsilon_0 \times \varepsilon \times A1/2T1 \times V1^2 \times (T1'^2/T1^2 - 1) \cdots \text{equation (11)}$$

Accordingly, when the number of the flexible sheets to be stacked (the times of superposition) is designated as X, the electric power J generated in the power generating element is represented by the equation (12):

$$J = (1/2) \times \varepsilon_0 \times \varepsilon \times A1/2T1 \times V1^2 \times (T1'^2/T1^2 - 1) \times (X - 1) \cdots \text{equation (12)}$$

Thus, according to the power generating element 210, it is possible to generate electric power that is proportional to the number of the flexible sheets 100 to be stacked, and therefore a larger amount of electric power may be generated as compared with conventional power generating elements.

Moreover, the power generating element 210 generates electric power by compressing and expanding the overlaid portion of the flexible sheets 100, as mentioned above; therefore, unlike conventional power generating elements that generate electric power through the expansion and contraction thereof, the flexible sheets 100 do not need to be gripped, and the flexible sheet 100 is unlikely to be deteriorated. Moreover, in the power generating element 210, the distance between the electrode layers 120 upon compression is likely to be more constant along a planar direction, as compared with the conventional power generating devices that generate electric power through the expansion and contraction thereof, and therefore a dielectric breakdown is less likely to occur.

Furthermore, since the power generating element 210 has a simple structure in which a plurality of flexible sheets 100 are superposed crosswise on each other and alternately folded in an accordion shape such that the flexible sheets 100 are alternately stacked, as mentioned above, the power generating element 210 can be easily produced. In particular, the flexible sheet 100 having an electrode layer 110 is to be folded and a plurality of electrodes are to be provided from a single electrode layer 110, and therefore a wiring to each electrode is unnecessary, leading to a simple wiring structure.

Furthermore, since the power generating device 201 includes the flexible sheet 100 having a three-layer structure in which a pair of dielectric elastomer layers 120 are laminated on the front and back face sides of the electrode layer 110, the folding of the flexible sheet 100 in an accordion shape reliably leads to the disposition of the dielectric elastomer layer 120 of the flexible sheet 100 between the electrode layers 110 of the pair of flexible sheets 100, and therefore the power generating device 201 can be easily produced.

Moreover, according to the power generating device 201, the pair of flexible sheets 100 are superposed on each other crosswise at substantially right angles, and therefore the area of a region in which the pair of flexible sheets 100 is superposed on each other may be increased, leading to generation of a larger amount of electric power. Further, the volume of the apparatus can be drastically reduced as compared with conventional power generating devices that generate electric power through stretching of a film constituted with a single layer or stacked several layers.

Modifications of Above-Described Power Generating Device and Power Generating Element (Other Second Embodiments)

It is to be noted that in addition to the aforementioned embodiments, the present invention can be carried out in various modes with alterations and/or improvements being made.

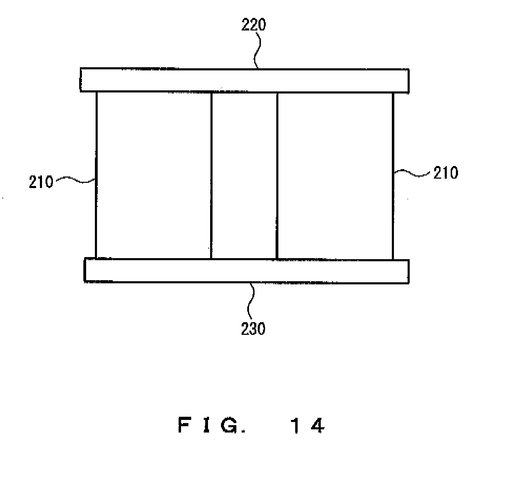

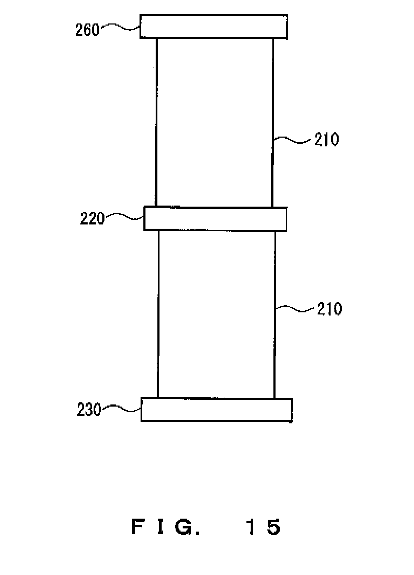

Specifically, although in the aforementioned second embodiment, the power generating device 201 that includes one power generating element 210 has been explained, the power generating device 201 may be appropriately modified such that the power generating device 201 includes a plurality of power generating elements 210, 210, similarly to the actuator according to the first embodiment. More specifically, a structure in which a first rigid member 220 is joined to one face side (upper face side) of a plurality of (two, in the embodiment shown) power generating elements 210, 210 and a second rigid member 230 is joined to the other face side (lower face side) of the plurality of power generating elements 210, 210, as shown in Fig. 14, may be employed. Furthermore, a structure in which a first rigid member 220, a second rigid member 230 and a third rigid member 260 are included and arranged parallel to one another and power generating elements 210, 210 are disposed between the first rigid member 220 and the second rigid member 230 and between the first rigid member 220 and the third rigid member 260, respectively, as shown in Fig. 15, may be employed.

Moreover, although in the aforementioned second embodiment, the power generating element 210 that includes the pair of dielectric elastomer layers 120 having an identical width has been explained, the present invention is not limited thereto, as mentioned above. Also in the power generating element 210, the flexible sheet shown in Fig. 7, for example, may be used.

Moreover, although in the aforementioned second embodiment, the pair of dielectric elastomer layers 120 having an identical thickness has been explained, the present invention is not limited thereto, as mentioned above. Moreover, a sum of the average thickness of the pair of dielectric layers 120 may also fall within a range identical to that defined in regard to the aforementioned first embodiment. In other words, a sum of the average thickness of the dielectric elastomer layers 120 is preferably no less than 20 $\mu$m and no greater than 200 $\mu$m, more preferably no less than 40 $\mu$m and no greater than 140 $\mu$m, and particularly preferably no less than 60 $\mu$m and no greater than 100 $\mu$m. When the sum of the average thickness of the dielectric elastomer layers 120 is less than the above lower limit, the dielectric elastomer layer 120 may be so thin that a dielectric breakdown of the dielectric elastomer layer 120 may be caused, and additionally an enormous number of flexible sheets 100 may be required to be stacked for the purpose of ensuring a sufficient height, i.e., the length along a stacking direction, of the power generating element 210, leading to an increase of a production cost. On the other hand, when the sum of the average thickness of the dielectric elastomer layers 120 is greater than the above upper limit, the electrodes may be spaced too far away from each other when being superposed, resulting in low capacitance and a less electric power generated.

Furthermore, although in the aforementioned second embodiment, the power generating element 210 in which the flexible sheets 100 are stacked to form a multilayer has been explained, the power generating element 210 according to the embodiment of the present invention may have a structure in which a pair of flexible sheets 100 are folded once and superposed crosswise on each other and alternately folded in an accordion shape such that the flexible sheets 100 are alternately stacked, and consequently four layers of the flexible sheet 100 in total are included, as shown in Fig. 8.

Moreover, although in the aforementioned second embodiment, the flexible sheet 100 having a three-layer structure has been explained, the present invention is not limited thereto. For example, a flexible sheet 100 that has a two-layer structure constituted with an electrode layer 110 and a dielectric elastomer layer 120, as shown in Fig. 8 mentioned above, may be used as the power generating element according to the embodiment of the present invention. Further, although the second embodiment in which a pair of flexible sheets 100 having an identical structure are included has been explained above, the present invention is not limited hereto; similarly to the first embodiment, the second embodiment may be appropriately modified such that a pair of flexible sheets 100 are constituted with flexible sheets 100 having a different structure, as shown in Fig. 9 mentioned above.

Furthermore, although the second embodiment in which the pair of flexible sheets 100 are folded has been explained above, the present invention is not limited thereto, and for example, a power generating element in which two pairs of flexible sheets are folded may be employed. More specifically, a power generating element in which each flexible sheet is superposed on each other crosswise at about 45° and alternately folded in an accordion shape such that the flexible sheets are alternately stacked may be employed.

Moreover, although the second embodiment in which the pair of flexible sheets 100 have an identical structure and the flexible sheet 100 has a pair of front and back dielectric elastomer layers 120 has been explained above, the present invention is not limited thereto; the second embodiment may be appropriately modified such that a flexible sheet having a different structure may be employed or a flexible sheet that includes front and back dielectric elastomer layers having a different structure may be used. However, the outermost surfaces of the pair of flexible sheets are preferably constituted with a layer that is made from an identical material and that has self-tackiness; in such a structure, a shape of an actuator element having the stacked structure is likely to be retained without an adhesive.

Example 2

Hereinafter, the present invention will be explained in more detail by way of Example, the present invention is not limited to the following Example.

Example 2

The flexible sheet used in this Example had a three-layer structure constituted with an electrode layer 110 having an average thickness of 10 $\mu$m and two dielectric elastomer layers each having an average thickness of 45 $\mu$m and laminated on front and back faces of the electrode layer 110.

The dielectric layer was provided using a forming material prepared by adding 30 parts by mass of a plasticizer to 100 parts by mass of ESPRENE (trade name) (manufactured by Sumitomo Chemical Co., Ltd.), and further adding barium titanate having a mean particle diameter of 0.5 $\mu$m as a dielectric filler in an amount of 25% by volume with respect to the total volume. Moreover, the electrode layer was provided using a forming material prepared by adding 30 parts by mass of a plasticizer to 100 parts by mass of ESPRENE (trade name) (manufactured by Sumitomo Chemical Co., Ltd.), and further adding carbon nanotubes as an electrically conductive filler in an amount of 2.8% by volume with respect to the total volume. It is to be noted that the dielectric elastomer layer and the electrode layer were each used after crosslinking.

The dielectric layer had a relative permittivity of 6.5.

The hardness (Duro A) of the dielectric layer determined at 20 °C using a type A durometer in accordance with JIS-K6253 (the measurement was carried out in triplicate and an average value of the measurements was calculated) was 6. Moreover, the hardness (Duro C) of the dielectric layer determined at 20 °C using a type C durometer in accordance with JIS-K7312 "type C hardness test" was 32.

Further, an elongation modulus determined at an elongation of 10% (M10) of the flexible sheet was 0.01 MPa, an elongation modulus determined at an elongation of 50% (M50) was 0.07 MPa, an elongation modulus determined at an elongation of 100% (M100) was 0.12 MPa, and an elongation modulus determined at an elongation of 400% (M400) was 0.49 MPa. It is to be noted that the determination of the elongation modulus was carried out using a dumbbell-type test piece (JIS No. 3) in accordance with JIS-K7312.

The tensile strength of the flexible sheet determined in accordance with JIS-K6323, "8.2 tensile test" was 2.2 MPa. Moreover, the elongation at break of the flexible sheet determined in accordance with JIS-K6732 was 1,079%.

The compressive modulus of elasticity of the flexible sheet determined in accordance with the method A in JIS-K-6254 was 0.5 MPa. More specifically, a test piece having a thickness of 12.5 $\pm$ 0.5 mm and a diameter of 29.0 $\pm$ 0.5 mm was compressed at a rate of 10 $\pm$ 1 mm/min until a 25% strain was attained, and immediately thereafter, unloading was allowed at the same rate. This operation was further repeated three times, and a strain and a force were recorded. A compressive force at strains of 10% and 20% was determined based on the fourth curve, and a compressive modulus of elasticity was calculated according to the equation.

The dielectric strength for DC of the flexible sheet determined in accordance with JIS-C2110-1,2 was 37.4 kV/mm. In this determination, a voltage-elevation procedure, a short time test, a shape of the electrode of $\Phi$20 mm spherical/ $\Phi$25 mm flat plate, and a test thickness of no greater than 1 mm were involved.

A power generating element was produced by superposing a pair of the flexible sheets crosswise and alternately folding the same in an accordion shape. In this instance, each flexible sheet was alternately folded seven times, and a power generating element 210 was produced in which eight layers of each flexible sheet 100, i.e., sixteen layers in total, were stacked.

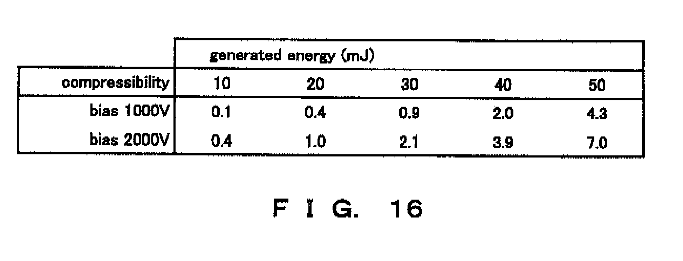

The stacked portion of the power generating element was compressed while applying a bias voltage to the power generating element. The bias voltage and compressibility were varied, and a generated energy was determined. The results are shown in Fig. 16.

As is clear from Fig. 16, the power generating element effectively generated electric power through the compression of the stacked portion.

[INDUSTRIAL APPLICABILITY]

The piezoelectric element according to the embodiments of the present invention can be used as an actuator element and a power generating element. For example, the piezoelectric element can be applied as an actuator to a wide variety of fields such as artificial muscles, since a contracted state of the piezoelectric element can be achieved through application of a voltage. Moreover, the piezoelectric element can be applied as a power generating element to a wide variety of fields that involve conversion of kinetic energies to electric power, since the electric power can be generated through compression of the stacked portion.

[EXPLANATION OF THE REFERENCE SYMBOLS]

| | |
|---|---|
| 1 | actuator |
| 10 | actuator element |
| 20 | first rigid member |
| 30 | second rigid member |
| 40 | control circuit |
| 100 | flexible sheet |
| 110 | electrode layer |
| 111 | connection portion |
| 120 | dielectric elastomer layer |
| 121 | sleeve portion |
| 201 | power generating device |
| 210 | power generating element |
| 220 | first rigid member |
| 230 | second rigid member |
| 240 | control circuit |
| 250 | bias voltage circuit |

**Claims**

1. A piezoelectric element, comprising a plurality of strip-shaped flexible sheets comprising:

a dielectric elastomer layer; and
an electrode layer that is stretchable and laminated on the dielectric elastomer layer,
the plurality of flexible sheets being superposed crosswise on each other and alternately folded in an accordion shape such that the flexible sheets are alternately stacked.

2. An actuator element comprising the piezoelectric element according to claim 1.

3. The actuator element according to claim 2, wherein at least one of the plurality of flexible sheets comprises a pair of the dielectric layers laminated on front and back face sides of the electrode layer.

4. The actuator element according to claim 2, wherein a pair of the flexible sheets are superposed on each other crosswise at substantially right angles and alternately folded in an accordion shape such that the flexible sheets are alternately stacked.

5. The actuator element according to claim 2, wherein the pair of flexible sheets are stacked to give no less than 10 layers and no greater than 10,000 layers.

6. The actuator element according to claim 2, wherein the dielectric layer has an average thickness of no less than 10 μm and no greater than 100 μm.

7. The actuator element according to claim 2, wherein an average thickness of the electrode layer is no greater than 1/10 of an average thickness of the dielectric layer.

8. An actuator comprising:

the actuator element according to claim 2;
a first rigid member joined to one face side of the actuator element; and
a second rigid member joined to other face side of the actuator element.

9. The actuator according to claim 8, wherein:

the actuator comprises a plurality of the actuator elements;
the first rigid member is joined to one face side of the plurality of actuator elements; and
the second rigid member is joined to other face side of the plurality of actuator elements.

10. A power generating element comprising the piezoelectric element according to claim 1.

11. The power generating element according to claim 10, wherein a pair of the flexible sheets are superposed on each other crosswise at substantially right angles and alternately folded in an accordion shape such that the flexible sheets are alternately stacked.

12. The power generating element according to claim 10, wherein at least one of the pair cf flexible sheets comprises a pair of the dielectric layers laminated on front and back face sides of the electrode layer.

13. The power generating element according to claim 10, wherein the dielectric layer has an average thickness of no less than 10 μm and no greater than 100 μm.

14. The power generating element according to claim 10, wherein an average thickness of the electrode layer is no greater than 1/10 of an average thickness of the dielectric layer.

15. The power generating element according to claim 10, wherein the pair of flexible sheets are stacked to give no less than 10 layers and no greater than 10,000 layers.

16. A power generating device comprising:

the power generating element according to claim 10;
a first rigid member joined to one face side of the power generating element; and
a second rigid member joined to other face side of the power generating element.

17. The power generating device according to claim 16, wherein:

the power generating device comprises a plurality of the power generating elements;
the first rigid member is joined to one face side of the plurality of power generating elements; and

the second rigid member is joined to other face side of the plurality of power generating elements.

18. A strip-shaped flexible sheet, comprising:

a stretchable electrode layer; and
a pair of dielectric elastomer layers laminated on front face and back face side of the electrode layer.

F I G.    1

F I G. 2

(A)

(B)

F I G. 3

F I G.    4

20

10

10

30

F I G. 5

50 — 

10

20 — 

10

30 — 

F I G.    6

F I G. 7

100

110

120

120     110     100

F I G.    8

F I G. 9

F I G. 1 0

F I G.  1 1

210

120

100

100

110

111

120

110

111

FIG. 12

F I G.　1 3

F I G.    1 4

F I G.    1 5

| compressibility | generated energy (mJ) | | | | |
|---|---|---|---|---|---|
| | 10 | 20 | 30 | 40 | 50 |
| bias 1000V | 0.1 | 0.4 | 0.9 | 2.0 | 4.3 |
| bias 2000V | 0.4 | 1.0 | 2.1 | 3.9 | 7.0 |

F I G. 16

**INTERNATIONAL SEARCH REPORT**

| International application No. |
| --- |
| PCT/JP2013/053426 |

A. CLASSIFICATION OF SUBJECT MATTER
*H02N11/00*(2006.01)i, *H02N2/00*(2006.01)i, *H02N2/18*(2006.01)i

According to International Patent Classification (IPC) or to both national classification and IPC

B. FIELDS SEARCHED

Minimum documentation searched (classification system followed by classification symbols)
H02N11/00, H02N2/00, H02N2/18

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | JP 2011-87423 A (Murata Mfg. Co., Ltd.), 28 April 2011 (28.04.2011), paragraphs [0034] to [0036]; fig. 5 (Family: none) | 1-18 |
| A | JP 2008-211922 A (Yamaha Corp.), 11 September 2008 (11.09.2008), paragraph [0012]; fig. 1 (Family: none) | 1-18 |
| A | JP 61-26206 A (Nippon Soken, Inc.), 05 February 1986 (05.02.1986), entire text; all drawings (Family: none) | 1-18 |

[X] Further documents are listed in the continuation of Box C.  [ ] See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 09 April, 2013 (09.04.13) | 23 April, 2013 (23.04.13) |

| Name and mailing address of the ISA/ Japanese Patent Office | Authorized officer |
| --- | --- |
| Facsimile No. | Telephone No. |

Form PCT/ISA/210 (second sheet) (July 2009)

**INTERNATIONAL SEARCH REPORT**

| | International application No. |
|---|---|
| | PCT/JP2013/053426 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2010-57321 A (Tokyo Institute of Technology), 11 March 2010 (11.03.2010), entire text; all drawings (Family: none) | 1-18 |

Form PCT/ISA/210 (continuation of second sheet) (July 2009)

**EP 2 816 724 A1**

**Patent documents cited in the description**

- JP 2011103713 A
- JP 2010057321 A
- JP 2003505865 PCT
- JP 2010263750 A